Europäisches Patentamt

European Patent Office

Office européen des brevets

(11) Publication number: **0 349 208 A2**

## (12) EUROPEAN PATENT APPLICATION

(21) Application number: **89306355.2**

(22) Date of filing: **23.06.89**

(51) Int. Cl.⁴: **G03F 7/00**

(30) Priority: **27.06.88 JP 85401/88 U**
**27.04.89 JP 49943/89 U**

(43) Date of publication of application:
**03.01.90 Bulletin 90/01**

(84) Designated Contracting States:
**DE FR GB**

(71) Applicant: **SEIKO INSTRUMENTS INC.**
**31-1, Kameido 6-chome Koto-ku**
**Tokyo 136(JP)**

(72) Inventor: **Nakamura, Haruki**
**c/o SEIKO INSTRUMENTS INC. 31-1, Kameido**
**6-chome**
**Koto-ku Tokyo(JP)**

(74) Representative: **Miller, Joseph et al**
**J. MILLER & CO. Lincoln House 296-302 High**
**Holborn**
**London WC1V 7JH(GB)**

(54) **Image forming apparatus.**

(57) An image forming apparatus comprising support means (1,5,62) for supporting an original (2) to be copied and for supporting a medium (11) provided with light-sensitive microcapsules; illuminating means (3) for illuminating the original (2); and exposure means (4) for exposing the said medium (11) to light from the original (2) characterised by temperature maintaining means (8-10) for maintaining a predetermined region of the medium (11) at a desired temperature or within a desired temperature range.

EP 0 349 208 A2

# IMAGE FORMING APPARATUS

This invention relates to an image forming apparatus.

A capsule rupture printing system is known for producing an image in an imaging sheet having at least one layer of subminiature capsules. US-A-4,399,209 and 4,440,846 and GB-A-2,113,860 (Mead Corporation) describe an imaging system wherein a photosensitive layer comprising microcapsules containing a photosensitive composition in the internal phase is image-wise exposed to actinic radiation and subjected to a uniform rupturing force, whereupon the microcapsules rupture and image-wise release the internal phase. An image-forming agent such as a substantially colourless chromogenic material is typically associated with the microcapsules such that when the microcapsules rupture the chromogenic material is able to react image-wise with a developer material and produce a colour image. Since this printing system can employ pixels of the same size as that of the microcapsules, that is in the order of $\mu$m, a colour image can be printed with extremely high resolution.

However, the sensitivity characteristics of the microcapsules are changed by the surrounding temperature, so that the quality of the recorded image can deteriorate. If the surrounding temperature is as low as 5°C, for example, the microcapsules have their L*a*b* colour difference as determined by the CIE (Commission Internationale de l'Eclairage) 1976 increasing to 20 or higher as compared with that at ordinary temperatures. If the surrounding temperature is as high as 40°C, the white ground density rises by about 40%.

According to the present invention, there is provided an image forming apparatus comprising support means for supporting an original to be copied and for supporting a medium provided with light-sensitive microcapsules; illuminating means for illuminating the original; and exposure means for exposing the said medium to light from the original characterised by temperature maintaining means for maintaining a predetermined region of the medium at a desired temperature or within a desired temperature range.

Preferably the temperature maintaining means comprises a temperature sensor for sensing the temperature of the said predetermined region; a temperature controller coupled to the temperature sensor; and heating and/or cooling means for heating and/or cooling the medium, the operation of the heating and/or cooling means being controlled by the temperature controller.

The temperature sensor is preferably disposed closely adjacent to but out of contact with the medium.

The heating and/or cooling means may comprise a heating plate having a resistor fixed thereon or therein.

The heating and/or cooling means may additionally or alternatively comprise a cooling plate having at least one Peltier effect element fixed thereon.

In one embodiment, the heating and/or cooling means comprises a roll over which in operation the medium passes, the roll having a hollow interior arranged to receive heated or cooled air.

In another embodiment, the heating and/or cooling means comprises blower means for blowing heated or cooled air onto the medium.

The blower means may be arranged to blow heated air from a heating pipe and cooled air from a cooling pipe onto the medium, each of said pipes being respectively provided with a shutter whose operation is controlled by the temperature controller.

In yet another embodiment, the heating and/or cooling means comprises a heating means and a cooling means which are juxtaposed on a heat insulator, means controlled by the temperature controller being provided for bringing either the heating means or the cooling means into an operative position in which it is disposed adjacent the said predetermined region.

The invention also comprises a method of forming an image by the use of the apparatus set forth above, the said method comprising supporting the original to be copied and the said medium; illuminating the original by means of the illuminating means; and exposing the said medium to light from the original characterised in that a predetermined region of the medium is maintained at a desired temperature or within a desired temperature range by the said temperature maintaining means.

The medium may be a photosensitive medium comprising a substrate, a developer layer formed on the substrate, and a multiplicity of light-sensitive microcapsules formed on the developer layer.

Alternatively, the medium may be a photosensitive medium comprising a substrate having a multiplicity of light-sensitive microcapsules formed thereon, the medium and a separate image-receiving sheet having a developer layer thereon being passed together through a common developing device.

As will be appreciated, the present invention enables images of high quality to be produced at all times even when the ambient temperature rises or falls.

In one form of the apparatus of the present invention, the temperature of the medium can be controlled without the necessity of providing a separate heat source additional to that used for fixing the image.

The invention is illustrated, merely by way of example, in the accompanying drawings, in which:-

Figure 1 is a schematic illustration showing an image forming apparatus according to the present invention which is designed for use in a one-sheet type printing system;

Figure 2 is a schematic block diagram showing a temperature control unit for use in the apparatus of Figure 1;

Figure 3 is a perspective view showing a heating device forming part of the apparatus of Figure 1;

Figure 4 is a schematic illustration showing an image forming apparatus according to the present invention which is designed for use in a two-sheet type printing system;

Figure 5 is a perspective view showing a cooling device which may be used in the apparatus of Figure 4;

Figure 6 is a schematic diagram showing another image forming apparatus according to the present invention which is designed for use in a two-sheet type printing system;

Figure 7 is a schematic diagram showing the construction of a temperature control unit which may be used in the Figure 6 apparatus;

Figure 8 is a schematic block diagram of the temperature control unit shown in Figure 7;

Figure 9 is a schematic diagram showing a contact type temperature control device which may be used in an image forming apparatus according to the present invention;

Figure 10 is a schematic diagram showing a constant temperature heating device which may be used in an image forming apparatus according to the present invention;

Figure 11 is a schematic diagram showing the construction of a heating/cooling unit which may be used in an image forming apparatus according to the present invention; and

Figure 12 is a schematic block diagram of the heating/cooling unit shown in Figure 11.

An image forming apparatus may be used on imaging sheet means of either the so-called one-sheet system, in which a single imaging sheet is coated with microcapsules having a chromogenic material, a photosensitive composition reactive to predetermined light to set the chromogenic material, and a developing material reactive with the chromogenic material to develop the colour; and the so-called two-sheet system in which two different sheets are respectively coated with the microcapsules and with the developing material.

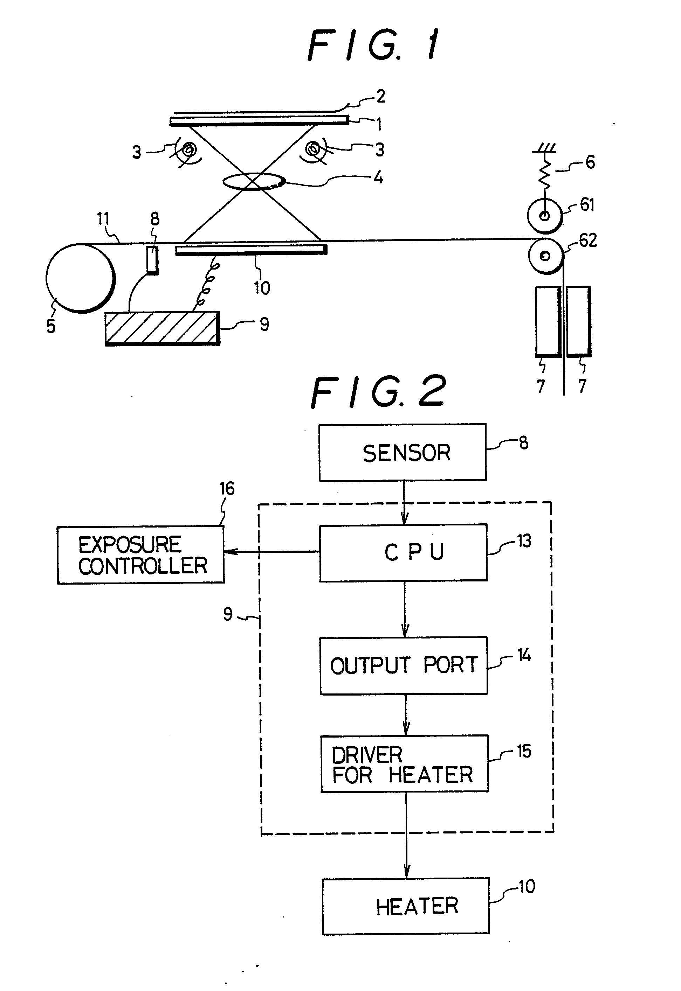

Figure 1 is a schematic illustration showing an image forming apparatus according to the present invention which is designed for use with the aforementioned one-sheet system. As shown in Figure 1, an original 2 to be copied is placed on an original image mount 1 comprising a glass plate. Light sources 3 illuminate the original 2. A lens 4 focuses an image of the original 2 into an imaging sheet 11 so as to expose the latter. The imaging sheet 11 is fed from a feed reel 5 and is transferred through a developing device 6 and a heat fixing device 7. A temperature control unit comprises a temperature sensor 8, such as a platinum temperature sensor, an infrared temperature sensor, a thermistor or a thermocouple, which is disposed downstream of the feed reel 5, a heating device 10 and a temperature controller 9.

In operation, the imaging sheet 11 is stopped once at its exposure position after having left the feed reel 5. Here, the temperature of the atmosphere in the vicinity of the imaging sheet 11 is detected by the temperature sensor 8 which is disposed in the vicinity of the heating device 10 but at a slight distance from the imaging sheet 11 so as to be out of contact with the latter. Temperature data from the temperature sensor 8 are transmitted to the temperature controller 9 so that the temperature of the atmosphere in the vicinity of the imaging sheeet 11 may always be set at a stable level.

Figure 2 is a schematic block diagram of the temperature control unit. The temperature data detected by the temperature sensor 8 are sent to a CPU 13 in the temperature controller 9. The CPU 13 is stored in advance with data for controlling the heating device 10 to a set temperature. If these temperature data are not coincident with those coming from the temperature sensor 8, the CPU 13 determines whether the heating device 10 is to be rendered operative or not. If the CPU 13 determines that the heating device 10 is to be rendered operative, a signal is fed from an output port 14 to a driver 15 according to the determination of the CPU 13, and a power signal is sent from the driver 15 to the heating device 10 so that the heating device 10 is arranged to hold the set temperature at all times. If, on the contrary, the temperature data are coincident with those of the CPU 13, a signal is sent from the CPU 13 to an exposure controller 16 so that a printing system (not shown) accomplishes its image forming operations. Generally, the sensitivity characteristics of the imaging sheet 11 deteriorate at a temperature lower than ordinary levels, e.g. 22°C. When the temperature sensor 8 detects a temperature of 10°C or lower, the temperature controller 9 operates the heating device 10 so that the temperature of the imaging sheet 11 may be at substantially ordinary levels.

The imaging sheet 11 thus heated is exposed to a projected beam coming from the lens 4. As a result, the imaging sheet 11 is not affected by the surrounding temperature. Then, the imaging sheet 11 is formed with a latent image which is composed of hardened capsules which have been reacted in accordance with the wavelength or wavelengths of the projected beam and unhardened capsules which have not been reacted with the said wavelength or wavelengths of the beam. After this, the imaging sheet 11 advances to the developing device 6 so that the unhardened capsules are broken, while the imaging sheet 11 is passing between two rollers 61 and 62, to cause the chromogenic material in the imaging sheet 11 to ooze onto a developing layer in the imaging sheet 11. Then the developed image on the imaging sheet 11 is thermally fixed by the heat fixing device 7.

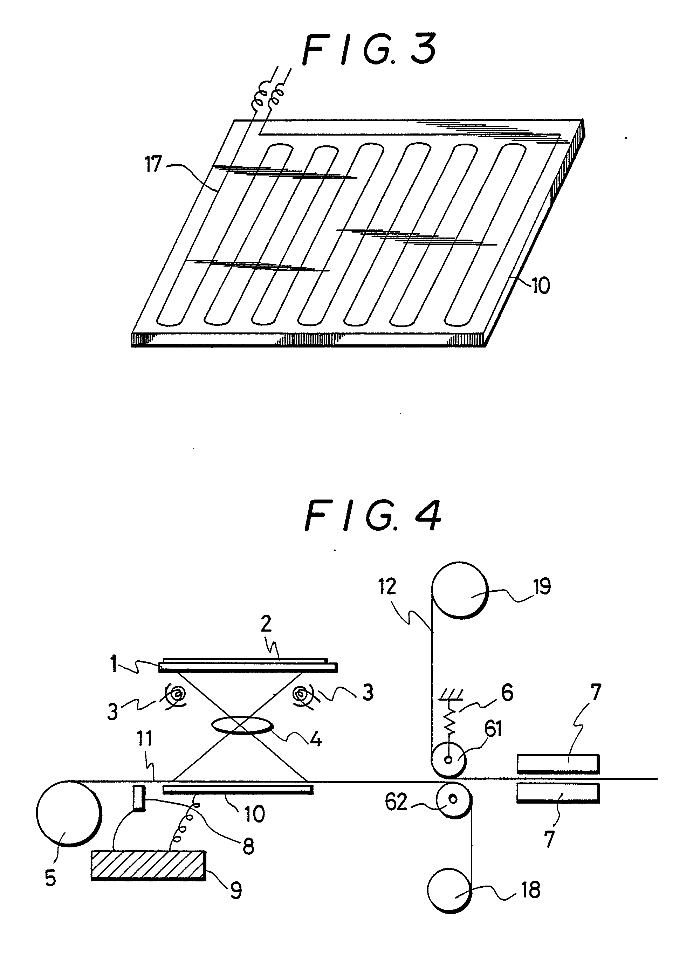

Figure 3 is a perspective view showing one example of the heating device which is constituted by a plate heater 10 having a resistor 17 fixed on its surface. The resistor 17, which is for generating heat, may be confined inside the structure to provide an effective ceramics heater or the like. Such a heating device 10 can effect an even heating and shorten the heating time.

Figure 4 is a schematic illustration showing an image forming apparatus according to the present invention which is designed for use with the two-sheet type of printing system. The construction of the exposing unit 1, 3, 4 of Figure 4 is the same as that of Figure 1, and its description will therefore be omitted here. The imaging sheet 11 is fed from the feed reel 5 and is taken up by a take-up reel 18 so as to pass over one roller 62 of a developing device 6. An image-receiving sheet 12 is fed from a feed reel 19 so as to pass over the other roller 61 of the developing device 6 until it is discharged after having passed through a heat fixing device 7. A temperature control device is composed of a temperature sensor 8, such as a platinum temperature sensor, an infrared temperature sensor, a thermistor or a thermocouple, which is disposed downstream of the feed reel 5, a heating device 10 and a temperature controller 9.

In operation, the imaging sheet 11 is stopped once at its exposing position after having left the feed reel 5. Here, the ambient temperature around the imaging sheet 11 is detected by the temperature sensor 8 which is disposed in a position similar to the temperature sensor 8 of Figure 1, and the temperature data are transmitted to the temperature controller 9 so that the temperature of the heating device 10 may be set at a stable level at all times. A detailed description of the operations of the temperature control device will be omitted because they are the same as those of the temperature control device of Figures 1 and 2. If the temperature is determined to be at a level of 10°C or lower, for example, by the temperature controller 9, the imaging sheet 11 is heated by the heating device 10 so that its temperature is raised to around the ordinary level. The imaging sheet 11 thus heated is exposed to a projected beam coming from a lens 4. As a result, any change in the sensitivity characteristics depending upon the temperature of the imaging sheet 11 can be ignored, whereby to avoid deterioration of the image quality. After the exposure, the imaging sheet 11 can be formed with a latent image which is composed of hardened capsules which have been reacted according to the wavelength or wavelengths of the projected beam and unhardened capsules which have not been reacted according to the wavelength or wavelengths of the beam. Next, this exposed portion of the imaging sheet 11 and the portion of the image-receiving sheet 12 which has left the feed reel 19 are guided to pass between the two pressure rollers 61 and 62 of the developing device 6, whereupon the unhardened capsules are broken so as to cause the chromogenic material in the imaging sheet 11 to ooze onto a developing material of the image-receiving sheet 12 and thereby to develop the colours. The developed image on the image-receiving sheet 12 is then thermally fixed by the heat fixing device 7 so as to form a colour image.

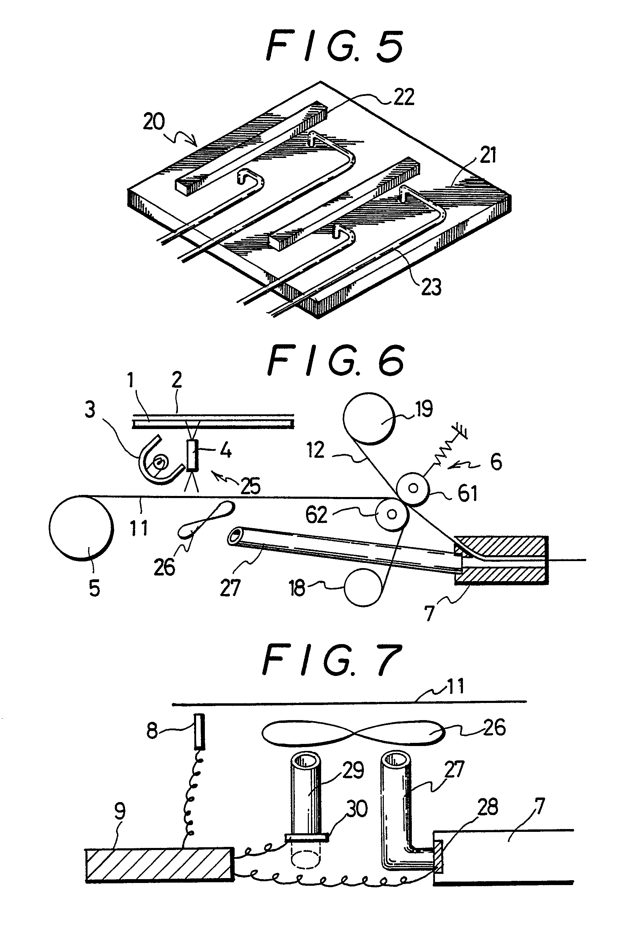

The sensitivity characteristics of the imaging sheet 11 also deteriorate if the temperature exceeds the ordinary levels, e.g. 22°C. By using a cooling device 20 shown in Figure 5 in place of the heating device 10, therefore, the imaging sheet 11 is cooled to around the ordinary temperatures by the temperature controller 9 if it is at a temperature, e.g. 40°C, which is higher than the ordinary levels. As a result, the imaging sheet 11 is prevented from suffering an image quality deterioration due to the temperature rise.

Figure 5 is a perspective view showing one example of the cooling device 20. To a metal plate 21 made of iron or the like, there are attached a cooling element 22 using a Peltier effect element and a heat pipe 23 for radiating the heat of the metal plate 21. Here, the cooling device 20 has its back facing the imaging sheet.

Figure 6 is a schematic diagram showing another image forming apparatus according to the present invention which is designed for use with the two-sheet type of printing system. Below the original image mount 1, there is disposed a scanning unit 25 which is comprised of a light source 3 and a lens 4. The scanning unit 25 is moved in parallel with and at a constant spacing from the original image mount 1 by drive mechanism (not shown) so as to scan the original 2. A temperature control unit is comprised of a blower fan 26 and a blower tube 27. The temperature control unit transmits heat from a heat fixing device 7 when the temperature of the imaging sheet 11 is lower than the ordinary levels. If the temperature of the imaging sheet 11 is higher than the ordinary levels, however, the transmission of heat from the heat fixing device 7 is stopped so that the ambient air sent from a fan disposed in the case of the apparatus is guided through a conduit (not shown) and is forced onto the imaging sheet 11 by the blower fan 26. The imaging sheet 11, whose temperature is thus controlled to around the ordinary temperatures, is exposed and is then taken up by a take-up reel 18 after passing over one pressure roller 62 of a developing device 6. At the same time, the image-receiving sheet 12 is fed from a feed reel 19 and is developed by passing over the other pressure roller 61 of the developing device 6 until it is thermally fixed by a heat fixing device 7 so as to form a colour image.

Figure 7 is a schematic diagram showing the construction of the temperature control unit of Figure 6. The temperature control unit is comprised of the temperature sensor 8 such as a platinum temperature sensor, an infrared temperature sensor, a thermistor or a thermocouple; the temperature controller 9; a blower shutter 28; the blower tube 27; an air introduction tube 29; an air introduction shutter 30; the blower fan 26; and the heat fixing device 7.

In operation, the temperature of the atmosphere in the vicinity of the imaging sheet 11 before the development is detected by the temperature sensor 8 and is transmitted to the temperature controller 9. If the temperature is determined to be at 10°C or lower, for example, the temperature controller 9 closes the air introduction shutter 30. Then, the blower shutter 28 attached to the heat fixing device 7 is opened to transmit heat from the heat fixing device 7 to the blower tube 27. A stream of hot air from the blown tube 27 is sent by the blower fan 26 to warm the imaging sheet 11. If the temperature of the atmosphere in the vicinity of the imaging sheet 11 is determined to be at 40°C or higher, for example, the temperature controller 9 then closes the blower shutter 28 and opens the air introduction shutter 30 so that the cool ambient air supplied from a fan (not shown) disposed in the case of the apparatus is introduced into the air introduction tube 29. A stream of cool air is thus sent by the blower fan 26 to cool the imaging sheet 11.

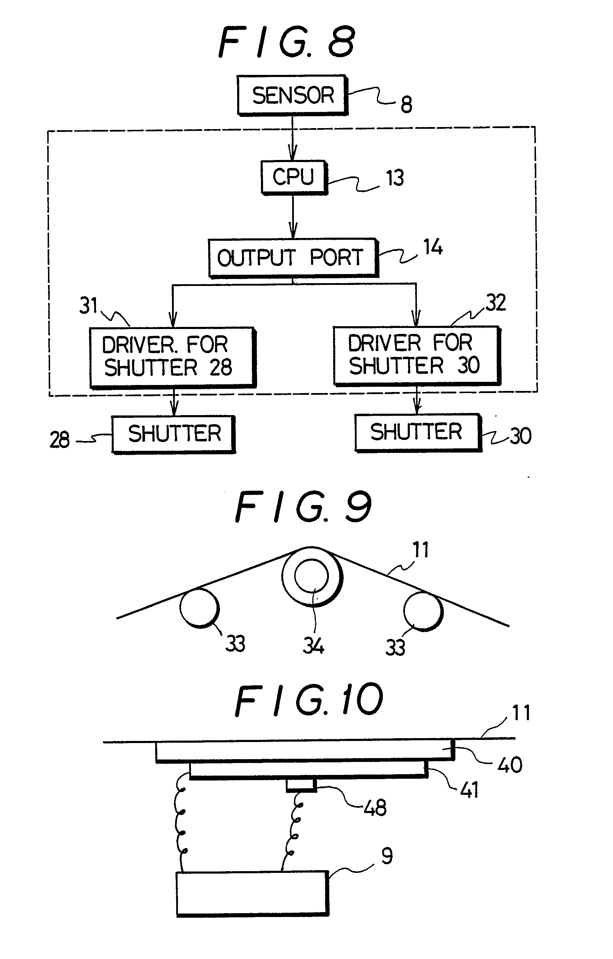

Figure 8 is a schematic block diagram showing a temperature control unit which may be used in the apparatus of Figure 7. The temperature data detected by the temperature sensor 8 are compared with the shutter selection data, which are stored in a CPU 13, to select whether the imaging sheet 11 is to be heated or cooled. Then, a signal is sent through an output port 14 to the driver of each of the shutters. Either a driver 31 for the blower shutter 28 or a driver 32 for the air introduction shutter 30 thus selected sends a control signal to its corresponding blower shutter 28 or air introduction shutter 30 to open or close the same shutter.

Since the heat of the heat fixing device 7 is used in the present embodiment for heating the imaging sheet, there is no necessity for employing a separate heat source. Moreover, this can also be done in the system using only one imaging sheet, as shown in Figure 1.

Figure 9 shows a contact type temperature control device which may be used in an image forming apparatus according to the present invention, whereas all the foregoing embodiments have employed a non-contact type temperature control.

In Figure 9, the temperature of the imaging sheet 11 conveyed through feed rollers 33 is detected by a temperature control device (not shown) which controls the temperature of a metal roll 34 over which the imaging sheet 11 passes. The means for controlling the temperature is accomplished by making the metal roll 34 hollow so as to allow heat from the heat fixing device 7 to be introduced into the hollow space or so as to allow cool air to be introduced into the interior of the metal roll 34. The metal roll 34, which has been thus controlled to around the ordinary temperatures, is brought into contact with the imaging sheet 11 to control the temperature of the imaging sheet 11 to around the ordinary temperatures so that the temperature control of the imaging sheet 11 can be accomplished in a short time. This method can be effectively applied to both the system of the single sheet of Figure 1 and the system using two sheets, i.e. the image system and the developing system of Figure 4.

Figure 10 is a schematic diagram showing a constant-temperature heating device of the imaging sheet contact type which may be employed in an image forming apparatus according to the present invention for setting the temperature of the heating device at a constant level at all times. An imaging sheet 11 is held in contact with a heating plate 40 made of iron or the like. A heater 41 is fixed to the heating plate 40 for raising the temperature of the latter. To the heater 41, there is directly fixed a temperature sensor 48 which comprises a thermistor for detecting the temperature of the heater 41. The temperature data detected by the temperature sensor 48 are transmitted to the temperature controller 9 to control the heater 41 to a constant temperature at all times. The temperature control of the heating plate 40 and the heater 41 is basically similar to that employed in Figure 1, and its description will therefore be omitted here.

The heating device 10 of Figure 3 and the cooling device 20 of Figure 5 can be juxtaposed with respect to each other and assembled together. In this case, the control of the heating and cooling devices can be accomplished no matter whether the temperature of the imaging sheet 11 is low or high.

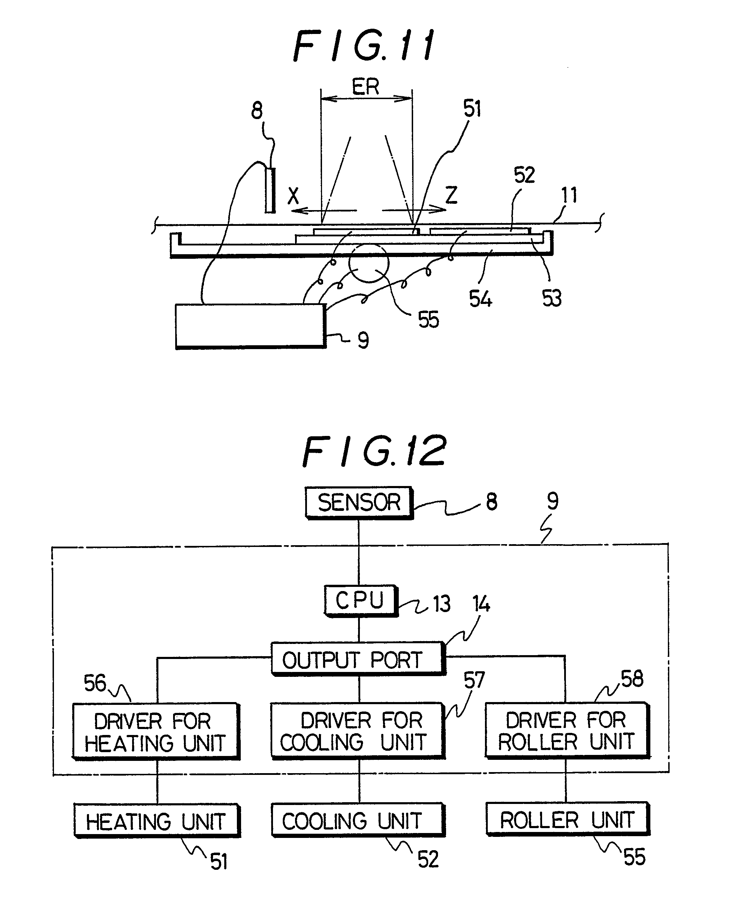

For example, Figure 11 is a schematic diagram showing the construction of a heating cooling unit which can be used in an image forming apparatus according to the present invention. On a heat insulator 53, there are fixed in a juxtaposed position a heating unit 51 having a width of at least an exposure range ER for allowing the exposure of the imaging sheet 11 and a cooling unit 52. A frame 54 is fixed so as to be parallel to the imaging sheet 11 and so as to guide and hold opposite ends of the heat insulator 53. A roller unit 55, which contacts the heat insulator 53, is arranged at the centre of the exposure range ER for moving the heat insulator 53 in X and Z directions. A temperature sensor 8 is positioned at a slight distance from the imaging sheet 11 and is arranged to detect the temperature in the vicinity of the imaging sheet 11. The temperature data detected by the temperature sensor 8 are sent to a temperature controller 9, which determines whether the imaging sheet 11 is to be heated or cooled. The determined data are sent to the roller unit 55 to bring either the heating unit 51 or the cooling unit 52 to a position below the exposure range ER. The unit selected by the temperature controller 9 then heats or cools the imaging sheet 11 so that the sheet 11 may be controlled to the predetermined temperature.

Figure 12 is a schematic block diagram showing the heating/cooling unit of Figure 11. The temperature data detected by the temperature sensor 8 are compared with unit selecting data which are stored in a CPU 13 for selecting either the heating unit 51 or the cooling unit 52. Then, a signal is sent through the output port 14 so that the roller unit 55 is operated by its driver 58. Simultaneously with the selection of the necessary unit, the output port 14 responds to the data from the CPU 13 to send a signal to a driver 56 or 57 for the heating unit 51 or the cooling unit 52 so that the imaging sheet 11 is heated or cooled to the predetermined temperature. The position of the heat insulator 53 is detected in response to a signal which comes from either a rotation detector (not shown) such as a magnetic encoder disposed on the roller unit 55 or a position detector (not shown) of the heat insulator 53 disposed on the frame 54.

In the embodiments of the present invention described above, the original image mount 1 is fixed. However, the original image mount can, if desired, be movable. Moreover, although the temperature control device can be disposed just below the exposure portion, it can also as shown be disposed just upstream of the exposure portion on the imaging sheet conveyance path.

If the side of the heating or cooling device, which contacts the imaging sheet or which is located at the side of the imaging sheet is coloured black or has an optical absorption wave-length, any optical reflection upon the imaging sheet from the heating or cooling device during the exposure is eliminated so as to ensure a clear image formation.

A change in the sensitivity characteristics of the imaging sheet depending the temperature is determined by the chemical substances in the capsules so that the temperature level for the sensitivity characteristic change is changed according to the change in the chemical substances. It is, therefore, possible to set the optimum heating temperature for each of the image sheets in accordance with the changes in their chemical substances.

In the embodiments described above, moreover, the temperature control of the imaging sheet has been accomplished by the temperature sensor 8. Without this temperature sensor 8, however, the temperature of the imaging sheet 11 can be confined within the predetermined temperature range so that the exposure can be effected without any deterioration of the image quality by holding the heating device or the cooling device at the set temperatures at all times.

A colour image of high quality can thus be achieved at all times even in cold or hot ambient conditions.

## Claims

1. An image forming apparatus comprising support means (1,5,62) for supporting an original (2) to be copied and for supporting a medium (11) provided with light-sensitive microcapsules; illuminating means (3) for illuminating the original (2); and exposure means (4) for exposing the said medium (11) to light from the original (2) characterised by temperature maintaining means (8-10) for maintaining a predetermined region of the medium (11) at a desired temperature or within a desired temperature range.

2. An image forming apparatus as claimed in claim 1 characterised in that the temperature maintaining means (8-10) comprises a temperature sensor (8) for sensing the temperature of the said predetermined region; a temperature controller (9) coupled to the temperature sensor (8); and heating and/or cooling means (10,20) for heating and/or cooling the medium (11), the operation of the heating and/or cooling means (10,20) being controlled by the temperature controller (9).

3. An image forming apparatus as claimed in claim 2 characterised in that the temperature sensor (8) is disposed closely adjacent to but out of contact with the medium (11).

4. An image forming apparatus as claimed in claim 2 or 3 characterised in that the heating and/or cooling means (10,20) comprises a heating plate (10) having a resistor (17) fixed thereon or therein.

5. An image forming apparatus as claimed in any of claims 2-4 characterised in that the heating and/or cooling means comprises a cooling plate (21) having at least one Peltier effect element fixed thereon.

6. An image forming apparatus as claimed in claim 2 or 3 characterised in that the heating and/or cooling means comprises a roll (34) over which in operation the medium (11) passes, the roll (34) having a hollow interior arranged to receive heated or cooled air.

7. An image forming apparatus as claimed in claim 2 or 3 characterised in that the heating and/or cooling means comprises blower means for blowing heated or cooled air onto the medium (11).

8. An image forming apparatus as claimed in claim 7 characterised in that the blower means (26) is arranged to blow heated air from a heating pipe (27) and cooled air from a cooling pipe (29) onto the medium (11), each of said pipes (27,29) being respectively provided with a shutter (28,30) whose operation is controlled by the temperature controller (9).

9. An image forming apparatus as claimed in any of claims 2-5 characterised in that the heating and/or cooling means comprises a heating means (51) and a cooling means (52) which are juxtaposed on a heat insulator (53), means (55) controlled by the temperature controller (9) being provided for bringing either the heating means (51) or the cooling means (52) into an operative position in which it is disposed adjacent the said predetermined region.

10. A method of forming an image by the use of the apparatus claimed in any preceding claim comprising supporting the original (2) to be copied and the said medium (11); illuminating the original (2) by means of the illuminating means (3); and exposing the said medium (11) to light from the original (2) characterised in that a predetermined region of the medium (11) is maintained at a desired temperature or within a desired temperature range by the said temperature maintaining means (8-10).

11. A method as claimed in claim 10 characterised in that the medium (11) is a photosensitive medium (11) comprising a substrate, a developer layer formed on the substrate, and a multiplicity of light-sensitive microcapsules formed on the developer layer.

12. A method as claimed in claim 10 characterised in that the medium (11) is a photosensitive medium (11) comprising a substrate having a multiplicity of light-sensitive microcapsules formed thereon, the medium (11) and a separate image-receiving sheet (12) having a developer layer thereon being passed together through a common developing device (6).

13. An image forming apparatus for forming an image on a transfer medium by pressing the transfer medium against a photosensitive medium having light sensitive microcapsules thereon, the apparatus comprising: an illuminating means for illuminating an original; exposure means for exposing said photosensitive medium to
light representative of the original; and temperature control means for controlling a temperature
of a predeetermined region of said photosensitive medium.

14. A method for forming an image on a transfer medium by pressing the transfer medium against a photosensitive medium having light sensitive microcapsules thereon, the method comprising:
feeding the photosensitive medium to an exposing position;
controlling a temperature of a predetermined region of the photosensitive medium; and
exposing the predetermined region of the photosensitive medium to light representative of the image to be formed thereon.

15. A method for forming an image on a photosensitive medium consisting of a substrate, a developer layer formed on said substrate, and a multiplicity of light sensitive microcapsules formed on said developer layer, the apparatus comprising:
feeding the photosensitive medium to an exposing position;
controlling a temperature of a predetermined region of the photosensitive medium; and
exposing the predetermined region of the photosensitive medium to light representative of the image to be formed thereon.

# F I G. 1

# F I G. 2

# F I G. 3

# F I G. 4

FIG. 5

FIG. 6

FIG. 7

## F I G. 8

SENSOR — 8

CPU — 13

OUTPUT PORT — 14

31 — DRIVER. FOR SHUTTER 28

32 — DRIVER FOR SHUTTER 30

28 — SHUTTER

SHUTTER — 30

## F I G. 9

11

33   34   33

## F I G. 10

11

40

41

48

9

## F I G. 11

## F I G. 12